# EUROPEAN PATENT APPLICATION

(11) **EP 4 750 227 A1**
(43) Date of publication of application: **27.05.2026**
(21) Application number: 25193411.3
(22) Date of filing: 01.08.2025
(51) Int. Cl.: H05K 1/02, H05K 1/11, H05K 1/181

(54) **PRINTED CIRCUIT BOARD ASSEMBLY, HEATING CONTROL CIRCUIT AND CONTROL METHOD THEREOF**

(30) Priority: 22.11.2024 CN 202411681303
(71) Applicant: Getac Technology Corporation, New Taipei City 221009 (TW)
(72) Inventor: CHEN, Li-Shing, 11568 Taipei City (TW); LEE, Yng-Wei, 11568 Taipei City (TW)
(74) Representative: Viering, Jentschura & Partner mbB Patent- und Rechtsanwälte

(57) **Abstract**

A printed circuit board assembly includes a circuit board, a heater resistor and a switch. The circuit board includes a component layer, a signal layer, a conductive layer and a conductive via. The component layer includes a mounting area for mounting a component. The signal layer includes first and second traces. The conductive layer is disposed between the component layer and the signal layer. The component layer includes a conductive pattern. The conductive via connects the first trace to the conductive pattern. The heater resistor includes a first terminal electrically connected to the first trace and a second terminal electrically connected to the second trace. The conductive pattern, the conductive via, the first trace, the heater resistor, the switch and the second trace are electrically connected in series between a power supply voltage terminal and a ground terminal.

## Description

### BACKGROUND

### Field of Invention

The present invention relates to a printed circuit board assembly, heating control circuit and control method thereof. More particularly, the present invention relates to a printed circuit board assembly, heating control circuit and control method thereof with heating functions.

### Description of Related Art

Nowadays, electronic components usually have operating temperature intervals over certain ranges. However, for cold regions, the extremely low temperature may be lower than the lower bound of the operating temperature intervals, and this may cause the components to not operate as intended.

Typically, for heating points of components mounted on small and scattered areas, issues exist such as difficulty in alignment and fixation, as well as high cost and low heating efficiency. Therefore, how to provide a printed circuit board assembly to solve the above problems is an important issue in this field.

### SUMMARY

The present disclosure provides a printed circuit board assembly. The printed circuit board assembly includes a circuit board, a heater resistor and a switch. The circuit board includes a component layer, a signal layer, a conductive layer and at least one conductive via. The component layer includes a mounting area for mounting a component. The signal layer includes a first trace and a second trace. The conductive layer is disposed between the component layer and the signal layer. The conductive layer includes a conductive pattern. The at least one conductive via connects the first trace to the conductive pattern. The heater resistor includes a first terminal electrically connected to the first trace and a second terminal electrically connected to the second trace. The conductive pattern, the at least one conductive via, the first trace, the heater resistor, the switch and the second trace are electrically connected in series between a power voltage terminal and a ground terminal.

The present disclosure provides a heating control circuit. The heating control circuit includes a heater resistor, a switch and an overtemperature protection circuit. The switch is electrically connected in series with the heater resistor between a power voltage terminal and a ground terminal. The switch includes a control terminal configured to receive a control signal. The overtemperature protection circuit is electrically connected between the heater resistor and the control terminal of the switch. The overtemperature protection circuit is configured to control the switch to turn off when a temperature at the heater resistor reaches a threshold value.

The present disclosure provides a control method for a heating control circuit. The heating control circuit includes a heater resistor and a switch electrically connected in series between a power voltage terminal and a ground terminal, an overtemperature protection circuit electrically connected between the heater resistor and a control terminal of the switch and a controller electrically connected to the control terminal of the switch. The control method includes the following steps. The switch is turned on, by the controller, according to temperature, such that a current flows from the power voltage terminal, the heater resistor and the switch to the ground terminal. Heat is produced, by the heater resistor, according to the current. The switch is controlled to turn off, by the overtemperature protection circuit, when a temperature at the heater resistor reaches to a threshold value.

In summary, the printed circuit board assembly of the present disclosure conducts the heat produced by the heater resistor through the conductive via to the conductive pattern which is adjacent to the component layer, thereby heating the component. Therefore, the heating control circuit and the control method of the present disclosure can provide heating functions, and can stop heating when the temperature reaches a target temperature.

### BRIEF DESCRIPTION OF THE DRAWINGS

The present disclosure can be more fully understood by reading the following detailed description of the embodiment, with reference made to the accompanying drawings as follows.
Fig. 1A and Fig. 1B depict a schematic diagram of a front and back of a printed circuit board assembly according to some embodiments of the present disclosure.
Fig. 2 depicts a schematic diagram of a printed circuit board assembly according to some embodiments of the present disclosure.
Fig. 3A depicts a schematic diagram of a function block of a heating control circuit according to some embodiments of the present disclosure.
Fig. 3B depicts a schematic diagram of a function block of a heating control circuit according to some embodiments of the present disclosure.
Figs. 4A to 4D depict schematic diagrams of different architectures consist of a control circuit and a printed circuit board assembly according to some embodiments of the present disclosure.
Fig. 5 depicts a schematic diagram of a function block of a heating control circuit according to some embodiments of the present disclosure.
Fig. 6 depicts a schematic diagram of a control method of a heating control circuit according to some embodiments of the present disclosure.

### DETAILED DESCRIPTION

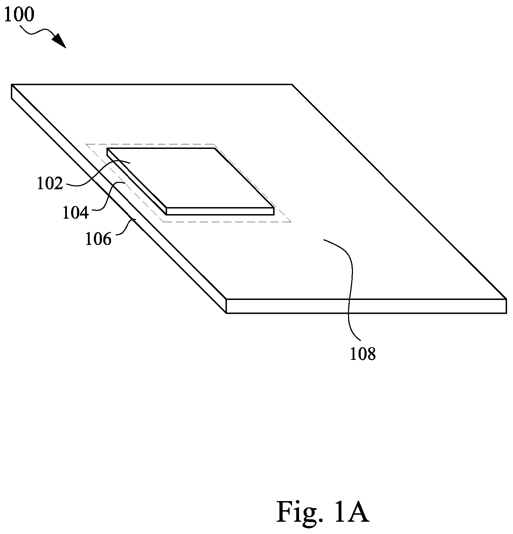

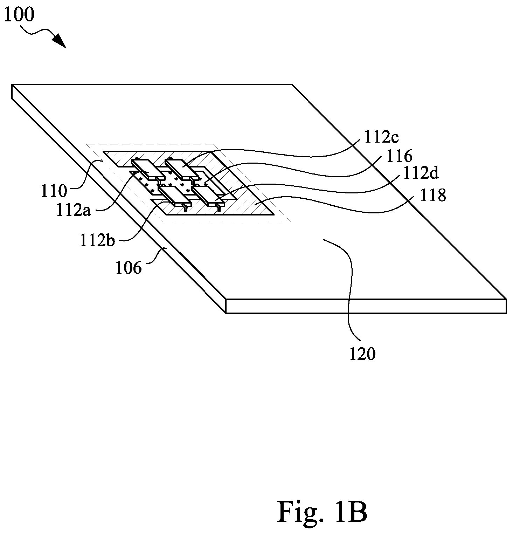

A description is provided with reference to Fig. 1A and Fig. 1B. Fig. 1A and Fig. 1B depict a schematic diagram of a front and back of a printed circuit board assembly 100 according to some embodiments of the present disclosure. In some embodiments, the printed circuit board assembly 100 includes a circuit board 106, a component 102 and heater resistors 112a-112d. In some embodiments, the component 102 can be a chip (such as, a central processing unit, a graphics processing unit or a tensor processing unit), a system on chip, a microcontroller or the other electronic components required to be heated to a temperature which is appropriate for operation in cold environments. In some embodiments, the heater resistors 112a-112d can be carbon film resistors, which have an advantage of low cost. As shown in Fig. 1A, the component 102 is mounted in a mounting area 104 on a top layer 108 of the printed circuit board assembly 100. Each of first terminals of the heater resistors 112a-112d is electrically connected to a first trace 116, and each of second terminals of the heater resistors 112a-112d is electrically connected to a second trace 118. In some embodiments, a horizontal projection of the area 110 on the bottom layer 120 overlaps a horizontal projection of the mounting area 104 on the top layer 108.

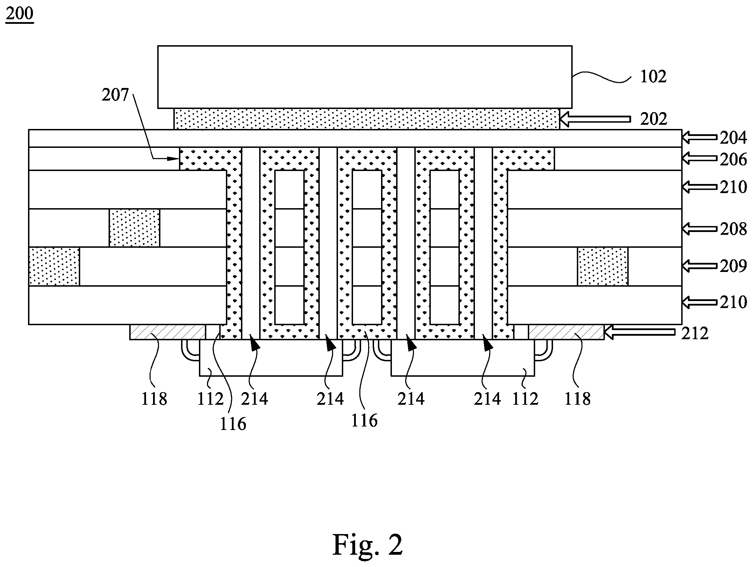

A description is provided with reference to Fig. 1A and Fig. 1B. Fig. 2 depicts a schematic diagram of a printed circuit board assembly 200 according to some embodiments of the present disclosure. In some embodiments, the printed circuit board assembly 200 corresponds to a portion of a cross section of the printed circuit board assembly 100 in Fig. 1A and Fig. 1B. In some embodiments, the printed circuit board assembly 200 includes a component 102, a component layer 202, at least two insulation layers (such as, an insulation layer 204 and at least one of insulation layers 210), one or more conductive layers 206 and 208-209 and a signal layer 212. In some embodiments, the insulation layer 204 is disposed between the component layer 202 and the conductive layer 206, and one or more insulation layer (such as, one of the insulation layers 210) disposed between the conductive layer 206 and the signal layer 212.

In some embodiments, the component 102 is mounted on the component layer 202 of the printed circuit board assembly 200, and the component layer 202 of the printed circuit board assembly 200 corresponds to the top layer 108 of the printed circuit board assembly 100 in Fig. 1A.

In some embodiments, the heater resistors 112 corresponds to two of the heater resistors 112a-112d in Fig. 1B (e.g., the heater resistors 112a-112b or 112c-112d). The heater resistors 112 are mounted on the signal layer 212 of the printed circuit board assembly 200. In some embodiments, the signal layer 212 of the circuit board included in the printed circuit board assembly 200 corresponds to the bottom layer 120 of the circuit board included in the printed circuit board assembly 100 in Fig. 1B. In some embodiments, a first terminal of each heater resistors 112 is electrically connected to the first trace 116 in the signal layer 212, and a second terminal of each heater resistors 112 is electrically connected to the second trace 118 in the signal layer 212.

In some embodiments, the printed circuit board assembly 200 includes a component layer 202, an insulation layer 204, a conductive layer 206, at least one insulation layers 210 and a signal layer 212. In some embodiments, the conductive layer 206 is adjacent to the component layer 202. In some embodiments, except the component layer 202, the conductive layer 206 can be a layer which is closest to the component 102.

In some embodiments, the conductive pattern 207 forms in the conductive layer 206. In some embodiments, the conductive pattern 207 is an independent copper foil. In some embodiments, a horizontal projection of the conductive pattern 207 overlaps a horizontal projection of the mounting area 104 in Fig. 1A and/or a horizontal projection of the area 110 in Fig. 1B. In some embodiments, the conductive via 214 connects the conductive pattern 207 included in the conductive layer 206 to the first trace 116. In some embodiments, the first trace 116 and the second trace 118 form in the signal layer 212.

In some embodiments, conductive portions of the circuit board in the printed circuit board assembly 100 (such as the conductive pattern 207 in the conductive layer 206, the first trace 116, the second trace 118 and the conductive via 214) are the conductive materials. In some embodiments, the conductive materials are metals. In some embodiments, the conductive materials are copper. Since the materials characterized in good electric conductivity also have good thermal conductivity, and therefore when the heater resistor produces heat, the heat energy can be transferred through the first trace 116 and the conductive via 214 to the conductive pattern 207. Meanwhile, the conductive pattern 207 can be considered as a thermal conductor. How to supply power to the heater resistors to produce heat will be described in detail in the following embodiments.

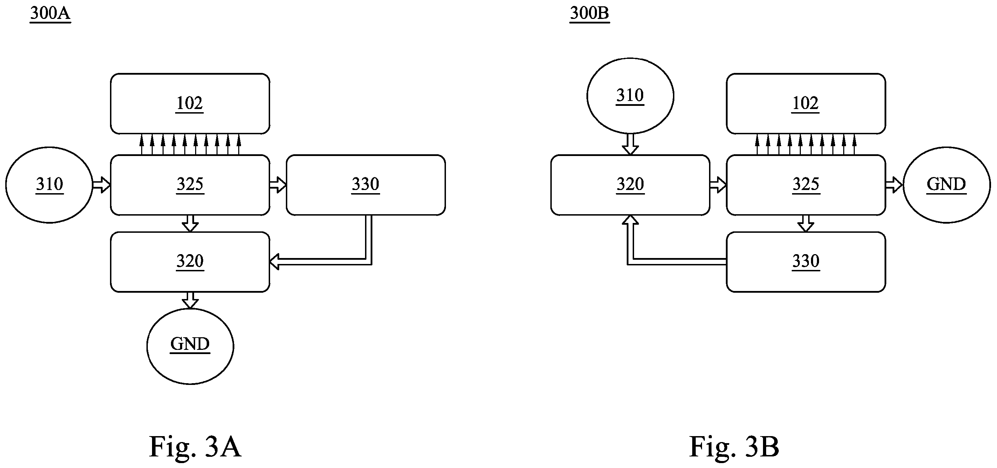

A description is provided with reference to Fig. 2 and Fig. 3A. Fig. 3A depicts a schematic diagram of a function block of a heating control circuit 300A according to some embodiments of the present disclosure. In embodiments of Fig. 3A, the switch 320 is disposed between the heating components 325 and the ground terminal GND. The power source 310 is connected to the heating components 325 (which include the heater resistors 112, the first trace 116, the conductive via 214 and the conductive pattern 207 in Fig. 2).

In some embodiments, when the switch 320 is turned off according to the control signal, an electric potential of a circuit consisting of the heating components 325 corresponds to a power voltage of the power source 310. In some embodiments, when the switch 320 is turned on according to the control signal, the power source 310, the heating components 325 and the ground terminal GND form a loop, a current flows from the power source 310, the heating components 325, the switch 320 to the ground terminal GND, such that the heater resistors (e.g., the heater resistors 112 in Fig. 2) included in the heating components 325 produce heat energy according to the current, and the heat energy is transferred, by heat conduction effect, to the other the components (e.g., the first trace 116, the conductive via 214 and the conductive pattern 207 in Fig. 2) included in the heating components 325.

In some embodiments, a point in time that the switch 320 is turned off is controlled by the overtemperature protection circuit 330. In some embodiments, the overtemperature protection circuit 330 changes a voltage level at a control terminal of the switch 320 when a temperature at the heating components 325 (which include the conductive pattern 207) exceeds a threshold value, thereby controlling the point in time that the switch 320 turns off.

A description is provided with reference to Fig. 2 and Fig. 3B. Fig. 3B depicts a schematic diagram of a function block of a heating control circuit 300B according to some embodiments of the present disclosure. In embodiments of Fig. 3B, the switch 320 is disposed between the heating components 325 and the power source310. The heating components 325 (including the heater resistors 112, the first trace 116, the conductive via 214 and the conductive pattern 207 in Fig. 2) are electrically connected to the ground terminal GND.

In some embodiments, when the switch 320 is turned off according to the control signal, an electric potential of a circuit consisting of the heating components 325 corresponds to a ground voltage of the ground terminal GND. In some embodiments, when the switch 320 is turned on, the power source 310, the heating components 325 and the ground terminal GND form a loop, a current flows from the power source 310, the switch 320, the heating components 325 to the ground terminal GND, such that the heater resistors (such as, the heater resistors 112 in Fig. 2) included in the heating components 325 produce heat energy according to the current, and the heat energy is transferred, by thermal conduction effect, to the other the components (such as, the first trace 116, the conductive via 214 and the conductive pattern 207 in Fig. 2) included in the heating components 325.

In some embodiments, a point in time that the switch 320 is turned off is controlled by the overtemperature protection circuit 330. In some embodiments, the overtemperature protection circuit 330 changes a voltage level at a control terminal of the switch 320 when a temperature at the heating components 325 (which include the conductive pattern 207) exceeds a threshold value, thereby controlling the point in time that the switch 320 turns off.

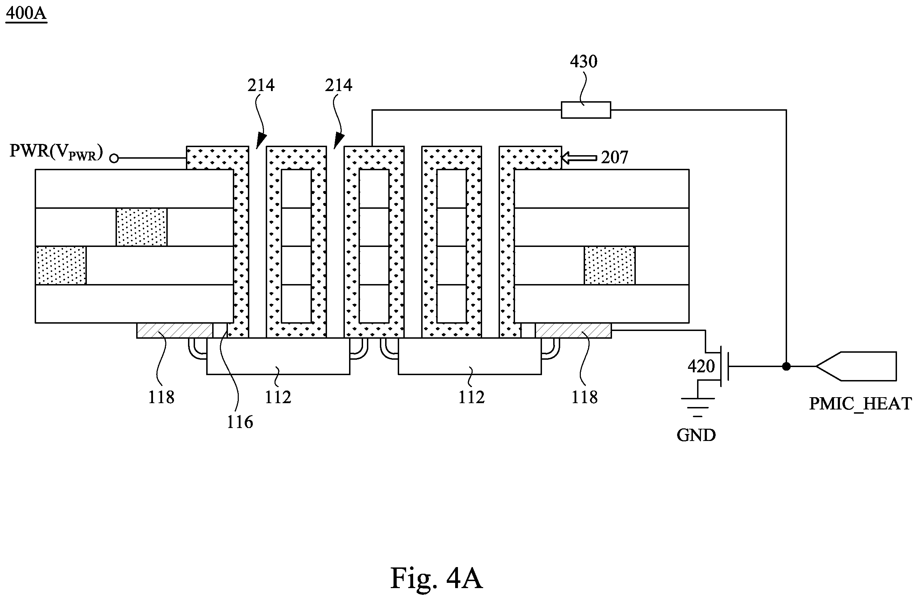

A description is provided with reference to Fig. 4A to Fig. 4D. Figs. 4A to 4D depict schematic diagrams of different architectures 400A-400D consist of a control circuit and a printed circuit board assembly 200 according to some embodiments of the present disclosure. For clarity, the component 102, the component layer 202 and the insulation layer 204 in Fig. 2 are not shown in Fig. 4A to Fig. 4D.

As shown in Fig. 4A, the switch 420 is electrically connected between the second trace 118 and the ground terminal GND, and the conductive pattern 207 is electrically connected to the power voltage terminal PWR, thereby receiving the power voltage V_{PWR}. In some embodiments, when the switch 420 is turned on according to the control signals PMIC_HEAT, a current flows from the power voltage terminal PWR through the conductive pattern 207, at least one conductive via 214, the first trace 116, the heater resistors 112, the second trace 118 and the switch 420 to the ground terminal GND.

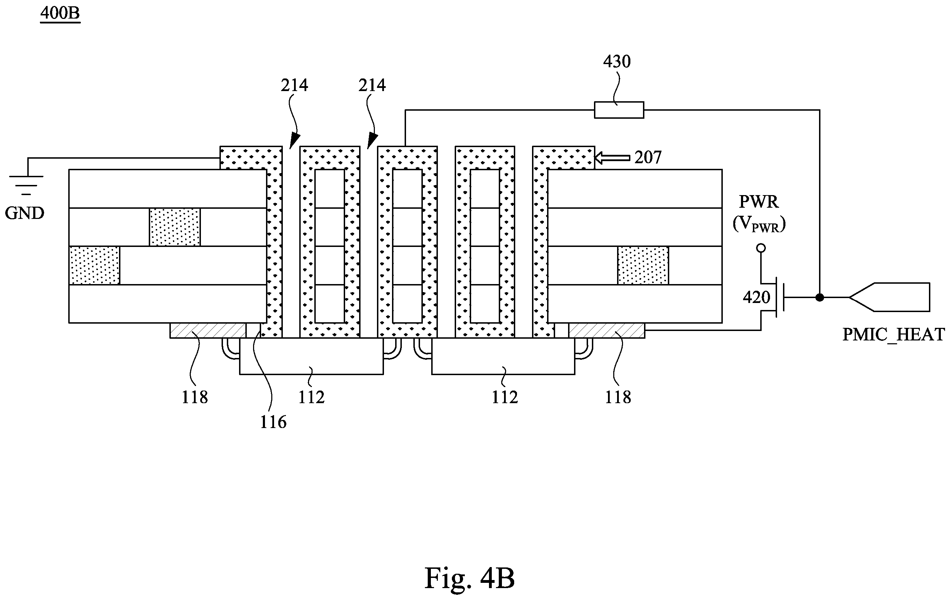

As shown in Fig. 4B, the switch 420 is electrically connected between the power voltage terminal PWR and the second trace 118, and the conductive pattern 207 is electrically connected to the ground terminal GND, thereby receiving the power voltage V_{PWR}. In some embodiments, when the switch 420 is turned on according to the control signals PMIC_HEAT, a current flows from the power voltage terminal PWR through the switch 420, the second trace 118, the heater resistors 112, the first trace 116, at least one conductive via 214 and the conductive pattern 207 to the ground terminal GND.

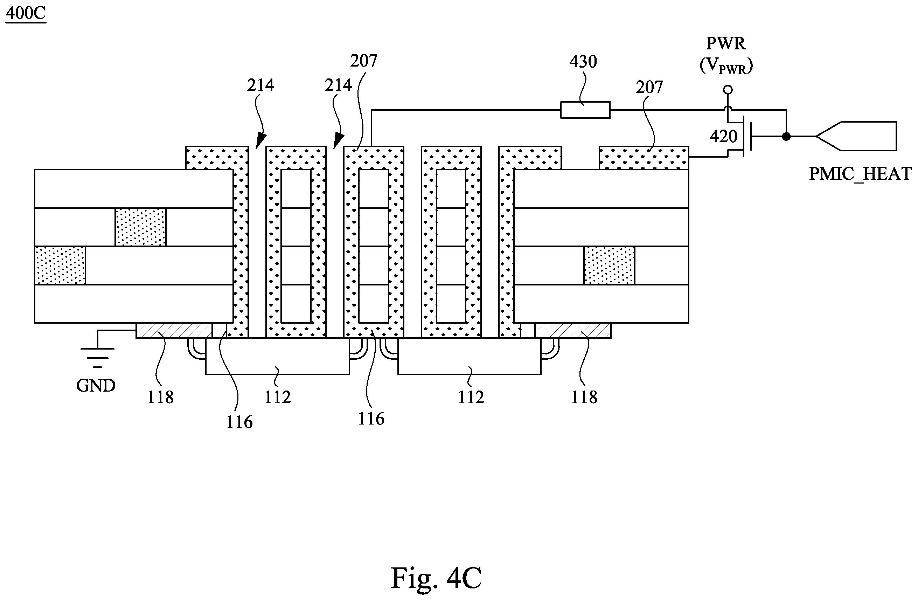

As shown in Fig. 4C, the switch 420 is electrically connected between the power voltage terminal PWR and the conductive pattern 207, and the second trace 118 is electrically connected to the ground terminal GND. In some embodiments, when the switch 420 is turned on according to the control signal PMIC_HEAT, a current flows from the power voltage terminal PWR through the switch 420, the conductive pattern 207, at least one conductive via 214, the first trace 116, the heater resistors 112 and the second trace 118 to the ground terminal GND.

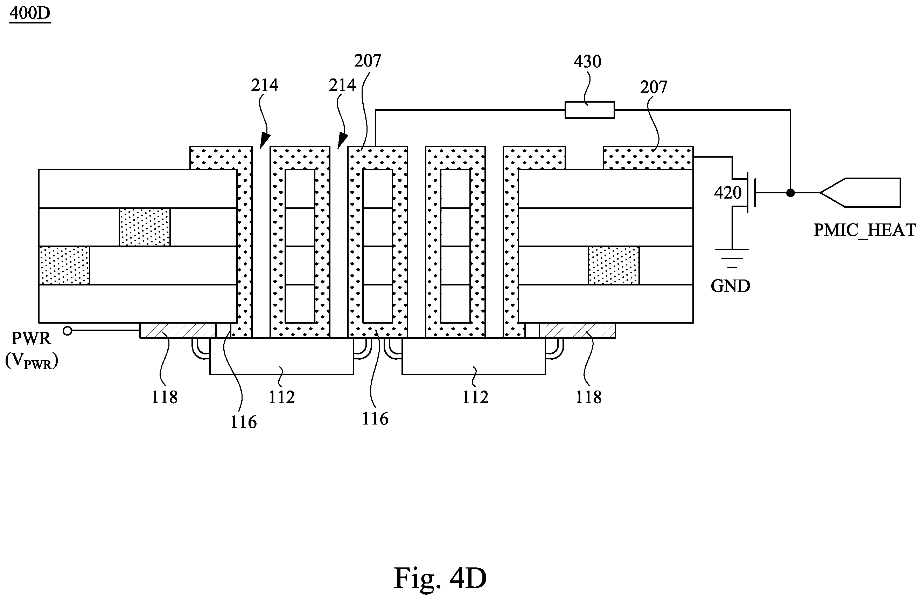

As shown in Fig. 4D, the switch 420 is electrically connected between the conductive pattern 207 and the ground terminal GND, and the second trace 118 is electrically connected to the power voltage terminal PWR. In some embodiments, when the switch 420 is turned on according to the control signal PMIC_HEAT, a current flows from the second trace 118, the heater resistors 112, the first trace 116, at least one conductive via 214, the conductive pattern 207 and the switch 420 to the ground terminal GND.

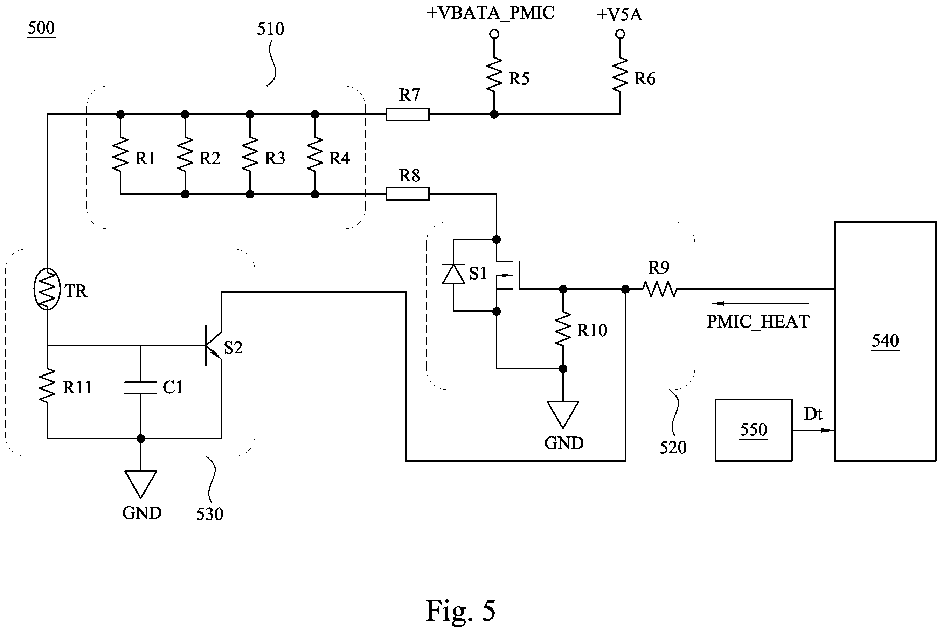

A description is provided with reference to Fig. 5. Fig. 5 depicts a schematic diagram of a function block of a heating control circuit 500 according to some embodiments of the present disclosure. As shown in Fig. 5, the heating control circuit 500 includes heating components 510, a switching circuit 520, an overtemperature protection circuit 530, a controller 540 and a temperature sensor 550. In some embodiments, the heater resistors R1~R4, the switch S1 and the overtemperature protection circuit 530 in Fig. 5 are respectively correspond to the heater resistors 112, the switch 420 and the overtemperature protection circuit 430 in Fig. 4A to Fig. 4D.

In some embodiments, the heating components 510 includes one or more heater resistors R1~R4. In some embodiments, the heating components 510 further include conductive vias and a conductive pattern (not shown in Fig. 5). In some embodiments, a first terminal of each of the heater resistors R1~R4 is configured to receive the power voltage +VBATA_PMIC from a battery (through resistors R7 and R5) or the power voltage +V5A from a power source (through resistors R7 and R6).

In some embodiments, the switching circuit 520 includes a switch S1 and resistors R9 and R10. In some embodiments, a first terminal of the switch S1 is electrically connected though a resistor R8 to the second terminals of the heater resistors R1~R4, and a second terminal of the switch is electrically connected to the ground terminal GND. In some embodiments, a control terminal of the switching circuit 520 is connected through the resistor R9 to the controller 540, in order to receive the control signals PMIC_HEAT provided by the controller 540. In some embodiments, the controller 540 is a microcontroller.

In some embodiments, the temperature sensor 550 can be disposed in the circuit board of the printed circuit board assembly, and the temperature sensor 550 is configured to sense a temperature in an environment. In some embodiments, the controller 540 receives the temperature Dt sensed by the temperature sensor 550, in order to determine whether the temperature Dt (e.g., the temperature in the environment) is less than a threshold value. In some embodiments, the threshold value corresponds to a lower limit of an operating temperature range of the component required to be heated.

In some embodiments, when the controller 540 determines that the temperature Dt (such as, -20°C) is less than the lower limit (such as, -10°C or - 0°C) of the operating temperature range of the component, the control signals PMIC_HEAT is applied to turn on the switch S1, such that a current flows from the power voltage terminal through the resistors R1~R4 and the switch S1 to the ground terminal GND, and thus the resistors R1~R4 produce heat according to the current, thereby transferring the heat to the conductive pattern.

In some embodiments, the overtemperature protection circuit 530 includes a switch S2, a capacitor C1, a resistor R11 and a thermistor TR. In some embodiments, the capacitor C1 and the resistor R11 are connected in parallel between a control terminal of the switch S2 and the ground terminal GND.

In some embodiments, the thermistor TR can be disposed adjacent to the conductive pattern (such as, the conductive pattern 207). As a result, the resistance of the thermistor TR changes with the temperature at the conductive pattern.

In some embodiments, the thermistor TR is electrically connected between first terminals of the heater resistors R1~R4 and a control terminal of the switch S2. In some embodiments, when a temperature at the conductive pattern (such as, the conductive pattern 207) reaches the lower limit (such as, -10°C or -0°C) of the operating temperature range of the component, the resistance of the thermistor TR decreases, causing an electrical potential at the control terminal of the switch S2 increase, thereby turning on the switch S2.

In some embodiments, the switch S2 is electrically connected between the control terminal of the switch S1 and the ground terminal GND. When the switch S2 is turned on, an electrical potential at the control terminal of the switch S1 will be pulled down, thereby turning off the switch S1. As a result, when the temperature at the conductive pattern (such as, the conductive pattern 207) reaches the lower limit (such as, -10°C or -0°C) of the operating temperature range of the component, the overtemperature protection circuit 530 turns off the switch S1, so as to stop heating.

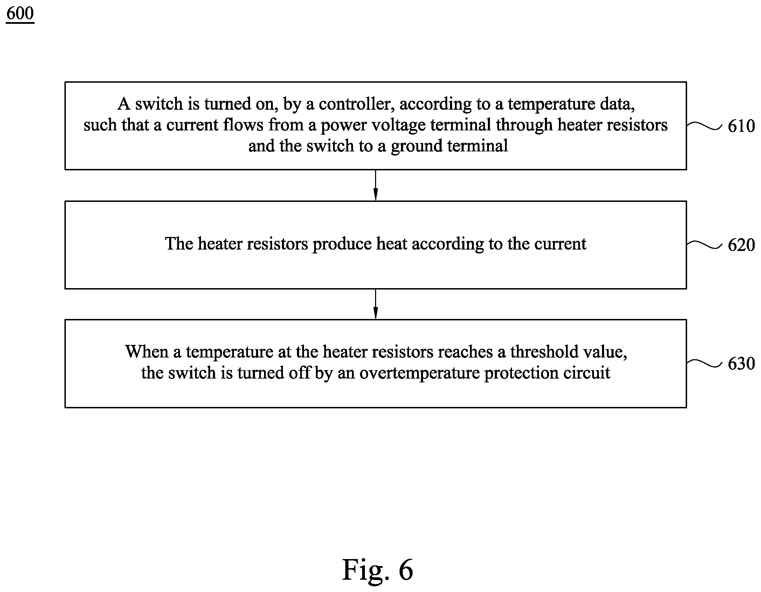

A description is provided with reference to Fig. 6. Fig. 6 depicts a schematic diagram of a control method 600 of a heating control circuit according to some embodiments of the present disclosure. **In** some embodiments, the control method 600 includes steps 610-630.

**In** step 610, a switch is turned on, by a controller, according to a temperature data, such that a current flows from a power voltage terminal through heater resistors and the switch to a ground terminal.

In step 620, the heater resistors produce heat in accordance with the current.

In step 630, when a temperature at the heater resistors reaches a threshold value, the switch is turned off by an overtemperature protection circuit.

In summary, the printed circuit board assembly 200 of the present disclosure conducts the heat produced by the heater resistors 112 through the conductive via 214 to the conductive pattern 207 which is adjacent to the component layer 202, thereby heating the component 102. Therefore, the heating control circuit 500 and the control method 600 of the present disclosure can provide heating functions, and can stop heating when the temperature reaches a target temperature.

## Claims

1. A printed circuit board assembly (100, 200), **characterized by** comprising:
a circuit board (106), comprising:
a component layer (202), comprising a mounting area (104) for mounting a component (102);
a signal layer (212), comprising a first trace (116) and a second trace (118);
a conductive layer (206) disposed between the component layer (202) and the signal layer (212), the conductive layer (206) comprising a conductive pattern (207); and
at least one conductive via (214) connecting the first trace (116) to the conductive pattern (207);
a heater resistor (112, R1-R4), comprising a first terminal electrically connected to the first trace (116) and a second terminal electrically connected to the second trace (118); and
a switch (320, 420, S1), wherein the conductive pattern (207), the at least one conductive via (214), the first trace (116), the heater resistor (112, R1-R4), the switch (320, 420, S1) and the second trace (118) are electrically connected in series between a power voltage terminal (PWR) and a ground terminal (GND).

2. The printed circuit board assembly (100, 200) of claim 1, wherein when the switch (320, 420, S1) is turned on according to a control signal (PMIC_HEAT), a current flows from the power voltage terminal (PWR) through the switch (320, 420, S1) and the heater resistor (112, R1-R4) to the ground terminal (GND).

3. The printed circuit board assembly (100, 200) of claim 1, wherein when the switch (320, 420, S1) is turned on according to a control signal (PMIC_HEAT), the heater resistor (112, R1-R4) produces heat energy according to a current, and wherein the at least one conductive via (214) is configured to transfer the heat energy produced by the heater resistor (112, R1-R4) to the conductive pattern (207).

4. The printed circuit board assembly (100, 200) of claim 1, 2, or 3, wherein the conductive pattern (207) is a thermal conductor, and a horizontal projection of the conductive pattern (207) overlaps at least part of a horizontal projection of the component (102).

5. The printed circuit board assembly (100, 200) of claim 1, 2, 3 or 4, wherein the circuit board (106) further comprises:
a first insulation layer (204), disposed between the component layer (202) and the conductive layer (206); and
at least one second insulation layer (210), disposed between the signal layer (212) and the conductive layer (206).

6. The printed circuit board assembly (100, 200) of claim 1, wherein the switch (420) is electrically connected between the second trace (118) and the ground terminal (GND), and wherein the conductive pattern (207) is electrically connected to the power voltage terminal (PWR).

7. The printed circuit board assembly (100, 200) of claim 6, wherein when the switch (420) is turned on according to a control signal (PMIC_HEAT), a current flows from the power voltage terminal (PWR) through the conductive pattern (207), the at least one conductive via (214), the first trace (116), the heater resistor (112), the second trace (118) and the switch (420) to the ground terminal (GND).

8. The printed circuit board assembly (100, 200) of claim 1, wherein the switch (420) is electrically connected between the power voltage terminal (PWR) and the second trace (118), and wherein the conductive pattern (207) is electrically connected to the ground terminal (GND).

9. The printed circuit board assembly (100, 200) of claim 8, wherein when the switch (420) is turned on according to a control signal (PMIC_HEAT), a current flows from the power voltage terminal (PWR) through the switch (420), the second trace (118), the heater resistor (112), the first trace (116), the at least one conductive via (214) and the conductive pattern (207) to the ground terminal (GND).

10. The printed circuit board assembly (100, 200) of claim 1, wherein the switch (420) is electrically connected between the power voltage terminal (PWR) and the conductive pattern (207), and wherein the second trace (118) is electrically connected to the ground terminal (GND).

11. The printed circuit board assembly (100, 200) of claim 10, wherein when the switch (420) is turned on according to a control signal (PMIC_HEAT), a current flows from the power voltage terminal (PWR) through the switch (420), the conductive pattern (207), the at least one conductive via (214), the first trace (116), the heater resistor (112) and the second trace (118) to the ground terminal (GND).

12. The printed circuit board assembly (100, 200) of claim 1, wherein the switch (420) is electrically connected between the conductive pattern (207) and the ground terminal (GND), and wherein the second trace (118) is electrically connected to the power voltage terminal (PWR).

13. The printed circuit board assembly (100, 200) of claim 12, wherein when the switch (420) is turned on according to a control signal (PMIC_HEAT), a current flows from the second trace (118), the heater resistor (112), the first trace (116), the at least one conductive via (214), the conductive pattern (207) and the switch (420) to the ground terminal (GND).

14. A heating control circuit (300A, 300B, 500), **characterized by** comprising:
a heater resistor (112, R1-R4);
a switch (320, 420, S1) electrically connected in series with the heater resistor (112, R1-R4) between a power voltage terminal (PWR) and a ground terminal (GND), the switch (320, 420, S1) comprising a control terminal configured to receive a control signal (PMIC_HEAT), wherein the switch (320, 420, S1) is turned on according to the control signal (PMIC_HEAT); and
an overtemperature protection circuit (330, 530), electrically connected between the heater resistor (112, R1-R4) and the control terminal of the switch (320, 420, S1), and wherein the overtemperature protection circuit (330, 530) is configured to control the switch (320, 420, S1) to turn off when a temperature at the heater resistor (112, R1-R4) reaches a threshold value.

15. A control method for a heating control circuit (500), **characterized in that** the heating control circuit (500) comprising a heater resistor (R1-R4) and a switch (S1) electrically connected in series between a power voltage terminal (PWR) and a ground terminal (GND), an overtemperature protection circuit (530) electrically connected between the heater resistor (R1-R4) and a control terminal of the switch (S1), and a controller (540) electrically connected to the control terminal of the switch (S1), the control method comprising:
turning on the switch (S1), by the controller (540), according to a temperature data (Dt), such that a current flows from the power voltage terminal (PWR), through the heater resistor (R1-R4) and the switch (S1) to the ground terminal (GND);
producing heat, by the heater resistor (R1-R4), according to the current; and
controlling the switch (S1) to turn off, by the overtemperature protection circuit (530), when a temperature at the heater resistor (R1-R4) reaches a threshold value.
